## Europäisches Patentamt
## European Patent Office
## Office européen des brevets

(19)

(11) Veröffentlichungsnummer : **0 118 396**
**B1**

(12) # EUROPÄISCHE PATENTSCHRIFT

(45) Veröffentlichungstag der Patentschrift :
06.05.87

(21) Anmeldenummer : 84810102.8

(22) Anmeldetag : 01.03.84

(51) Int. Cl.⁴ : **G 01 R 19/00**, G 01 R 29/24, G 01 R 5/28

(54) **Messverfahren für ein elektrisches Signal, serie-parallel-gegengekoppelter Messkreis sowie Verwendung des Verfahrens oder des Messkreises zur Messung von Spannungsquellen mit höchstohmigen Innenimpedanzen.**

(30) Priorität : 04.03.83 DE 3307693

(43) Veröffentlichungstag der Anmeldung :
12.09.84 Patentblatt 84/37

(45) Bekanntmachung des Hinweises auf die Patenterteilung : 06.05.87 Patentblatt 87/19

(84) Benannte Vertragsstaaten :
AT BE CH DE FR GB IT LI LU NL SE

(56) Entgegenhaltungen :
WO-A-82 /027 75
PROCEEDINGS IEE, Band 126, Nr. 11R, November 1979, Seiten 1053-1068, IEE Reviews, Stevenage, GB., R.W.J. BARKER: "Modern electrometer techniques"
MEASUREMENT TECHNIQUES, Band 25, Nr. 10, Oktober 1982, Seiten 833-835, New York, USA, N.I. FECHIN et al.: "Modular electrometer amplifier"

(73) Patentinhaber : TROESCH, Jacques J.
Walchestrasse 19
CH-8035 Zürich (CH)

(72) Erfinder : TROESCH, Jacques J.
Walchestrasse 19
CH-8035 Zürich (CH)

(74) Vertreter : Troesch, Hans Alfred, Dr. Ing. et al
Walchestrasse 19
CH-8035 Zürich (CH)

## Beschreibung

Die vorliegende Erfindung betrifft ein Verfahren zum Messen einer Gleichspannung oder einer sich langsam verändernden Spannung über einer oder in Serie zu einer sehr hochohmigen Impedanz, insbesondere einer hochwertigen Kapazität oder einer sehr hochohmigen Spannungsquelle mittels eines serie-parallel-gegengekoppelten Verstärkerkreises, der einen Eingangsverstärker mit vorgeschalteter Schwingkapazität, deren Kapazitätswert über eine Schwingung mit vorgegebener fester Frequenz steuerbar ist, aufweist, die durch die zu messende Spannung aufgeladen wird, so dass an der Schwingkapazität eine mit der Aufladung amplitudenmodulierte Wechselspannung entsteht, die ausgefiltert und zu einem amplitudenabhängigen Signal demoduliert wird, das in den Eingangskreis rückgeführt wird sowie einen serie-parallel-gegengekoppelten Messkreis zur Durchführung des Verfahrens mit einem Eingangsverstärker, mit vorgeschalteter Schwingkapazität sowie nachgeschalteter Demodulationseinheit für das schwingkapazität-bewirkte Wechselsignal, wobei ein vom Ausgangssignal der Demodulationseinheit abhängiges Signal auf den Eingang des Messkreises zurückgeführt ist.

## Stand der Technik

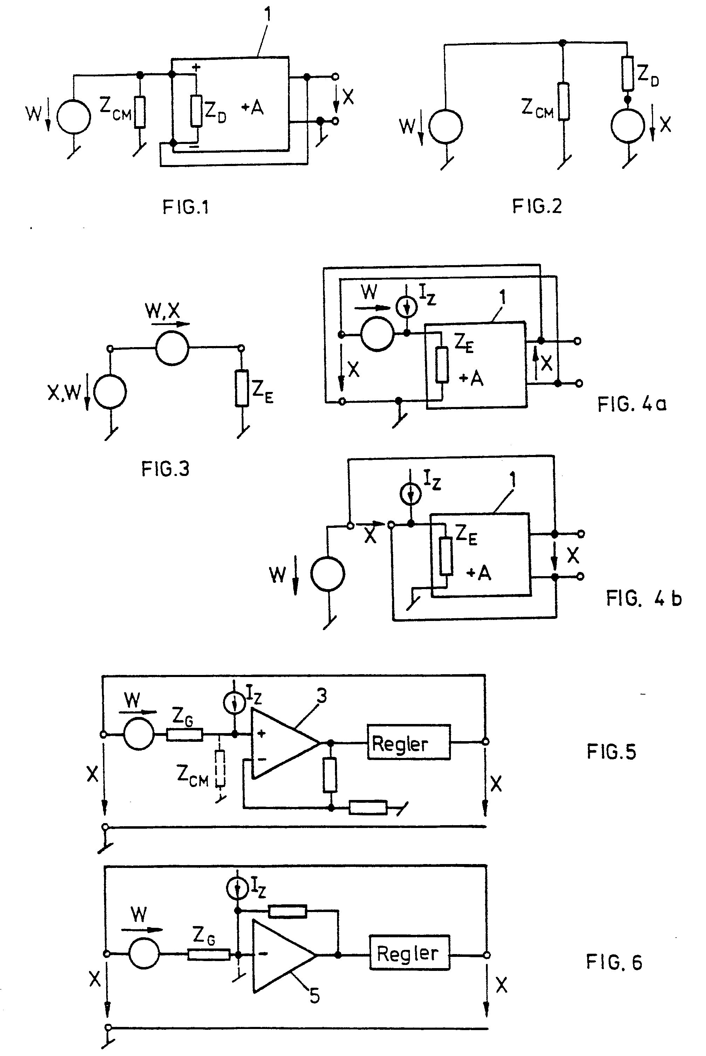

Serie-parallel gegengekoppelte Messverstärkerkreise sind bekannt. Darunter fällt beispielsweise der als Folger geschaltete Operationsverstärker, bei welchem die Ausgangsspannung der Eingangsspannung gegengekoppelt wird. In Fig. 1 ist das Blockschema eines als Folger geschalteten Verstärkers dargestellt. Das zu messende Signal W als Führungsgrösse, wird dem positiven Eingang des Verstärkers 1 zugeführt, das Ausgangssignal X, als Regelgrösse, dadurch der Führungsgrösse W gegengekoppelt, dass der Ausgangsanschluss auf den negativen Eingang des Verstärkers 1 rückgeführt ist. Die Verstärkung des Verstärkers 1 ist mit +A bezeichnet. Betrachtet man die Eingangsimpedanzverhältnisse, die sich der Führungssignalquelle W darbieten, so ist ersichtlich, dass erstens die Common-mode-Impedanz $Z_{CM}$ in Rechnung zu stellen ist, zweitens die differentielle Eingangsimpedanz $Z_D$. Aus dem entsprechenden Eingangs-Ersatzschaltbild von Fig. 2 ist ersichtlich, dass, da lediglich die Regeldifferenz des Kreises über der differentiellen Eingangsimpedanz $Z_D$ liegt, diese vernachlässigbar ist, nicht jedoch die Common-mode-Impedanz $Z_{CM}$. Die mit einer solchen Schaltung maximal erreichbare Eingangsimpedanz ist somit die Common-mode-Impedanz $Z_{CM}$, die sich, für tiefste Frequenzen, üblicherweise bei Operationsverstärkern in der Grössenordnung von $10^{-12}\Omega$ resp. $1T\Omega$ bewegt. Im übrigen ist es bekannt, dass der Eingangsstrom des Verstärkers 1 gemäss Fig. 1 in die Führungssignalquelle W einfliesst. Führungssignalquellen mit extrem hochohmigen Innenimpedanzen, wie mit rein kapazitiver Innenimpedanz, können mit dieser Anordnung nicht ausgemessen werden. Es ist ja bekannt, dass die Eingangsströme von als Folger geschalteten Operationsverstärkern gerade so gemessen werden, dass eine Kapazität zwischen Masse und positivem Eingang geschaltet wird und aus dem Spannungsanstieg am Ausgang X pro Zeiteinheit auf den auf die Kapazität fliessenden Strom geschlossen wird.

Um vorerst das Prinzip der Serie-Parallel-Gegenkopplung für die Erhöhung der Eingangsimpedanz eines Messverstärkerkreises voll auszunützen, muss das Eingangsersatz-Schaltbild, wie in Fig. 3 dargestellt, ausgelegt werden. Die Eingangsimpedanz $Z_E$ des Messverstärkerkreises erscheint nun in Serie zur Führungssignalquelle W und Regelgrössenquelle X.

In den Fig. 4a und 4b sind die beiden Konfigurationen der Serie-Parallel-Gegenkopplung als Blockschaltbild dargestellt, in Fig. 4a ist die Führungssignalquelle W potentialfrei zugeschaltet, in Fig. 4b die Regelgrösse X.

Es sind verschiedene Vorschläge gemacht worden, das Prinzip gemäss den Fig. 3 und 4 für Messverstärkerkreise mit extrem hoher Eingangsimpedanz zu realisieren. Hierzu sei beispielsweise auf « applications of operational amplifiers » aus « Burr-Brown, Electronics Series, McGraw-Hill, 1973 », Seite 42 hingewiesen, wo die auszumessende Spannungsquelle die Führungssignalquelle, zwischen invertierendem Eingang und Ausgang eines Operationsverstärkers geschaltet wird. Der nicht invertierende Eingang wird beispielsweise auf Masse geschaltet. Bei dieser Anordnung ist die von der Führungssignalquelle her gesehene Eingangsimpedanz durch die Impedanz zwischen Eingang und Ausgang des Operationsverstärkers gegeben. Eine weitere Realisierung dieses Prinzips zum Erhalt von Messverstärkerkreisen mit extrem hoher Eingangsimpedanz aus in « Rev. of Scientific Instr., Vol. 51 (1980) Feb., No. 2, New York » bekannt geworden.

Unter dem Titel « Circuit for the measurement of surface potential changes by the static capacitor method » wird hier prinzipiell die Schaltungsanordnung gemäss Fig. 4a realisiert. Da mit diesem Prinzip extrem hohe Eingangsimpedanzen erzielbar sind — die Eingangsimpedanz des Verstärkers wird durch die Verstärkung des offenen Regelkreises hochtransformiert — wird es damit möglich, Spannungsquellen mit höchsten Innenimpedanzen, im Extrem kapazitive Gleichspannungsquellen, auszumessen. Diese Methode, als « static capacitor method » bezeichnet, wird hier verwendet, um Potentialänderungen bei der Adsorption von Gasen an Metallfolien zu erfassen. Der in diesem Artikel verwendete Schaltungsaufbau ist Prinzipiell in Fig. 5 dargestellt. Die auszumessende Signalquelle W ist über die Innenimpedanz der Quelle $Z_G$ auf einen als nicht invertierender Verstärker geschalteten Operationsverstärker 3 geschaltet, dessen Ausgang über einen Regler auf den Eingang rückgeführt ist. Die Regelgrösse X wird ausgewertet. Die Innenimpedanz der Führungssignalquelle W ist praktisch rein kapazitiv. Der Nachteil dieser Schaltung ist nun darin zu sehen, dass durch die Innenimpedanz $Z_G$ und die Common-mode-Impedanz $Z_{CM}$ des Operationsverstärkers 3 ein Spannungsteiler entsteht. Unter Berücksichtigung, dass die Innenimpedanz $Z_G$ bei tiefen Frequenzen wesentlich grösser wird als die Common-mode-Impedanz $Z_{CM}$ des Operationsverstärkers 3, handelt es sich doch bei $Z_G$ um eine Vakuumskapazität, so ist ersichtlich, dass zum Erzielen einer guten Folgegenauigkeit der Regelgrösse X mit Bezug auf die Führungsgrösse W, die Verstärkung des Operationsverstärkers 3 und des nachgeschalteten Reglers diese Abschwächung kompensieren muss.

Diesbetreffend vorteilhafter ist das in Fig. 6 dargestellte Schaltungsprinzip, bei welchem als Eingangsverstärker 5 ein Operationsverstärker in invertierender Schaltungskonfiguration verwendet wird. Dieses Prinzip ist in der PCT-Anmeldung, veröffentlicht unter der Nummer WO 82/02775 desselben Anmelders wie der vorliegenden Anmeldung, beschrieben. Grundsätzlich können die anhand der Fig. 3 bis 6 dargestellten Verfahren ein sehr gutes dynamisches Verhalten aufweisen, indem die vorgesehenen Regler so ausgelegt werden können, dass der offene Regelkreis auch bei hohen Frequenzen noch eine hohe Verstärkung aufweist. Zudem weisen Messkreise, gemäss den Fig. 3 bis 6 aufgebaut, extrem hohe Eingangsimpedanzen auf. So wird insbesondere gemäss Fig. 6 die Eingangsimpedanz $Z_G$, bei der Ausmessung höchstohmiger Spannungsquellen direkt durch die Quelleninnenimpedanz gebildet, mit der Verstärkung des offenen Regelkreises hochtransformiert, was, wenn es sich bei $Z_G$ um eine reine Kapazität handelt, zu extrem hohen DC-Eingangsimpedanzen des Messkreises führt.

Das bereits oben angetönte zweite Problem wird jedoch durch diese bekannten Messverfahren nicht gelöst, nämlich dass der, in den Fig. 4a bis 6 eingezeichnet, als Störgrösse, wirkende Eingangsstrom $I_Z$ des Eingangsverstärkers nach Massgabe der Verstärkung des offenen Regelkreises praktisch vollständig auf die Quellen-Innenimpedanz $Z_G$ fliesst. Dies verhindert, dass derartige Kreise zur Langzeitausmessung derart hochohmiger Spannungsquellen eingesetzt werden können. Handelt es sich bei der Impedanz $Z_G$ um eine hochwertige Kapazität, praktisch also $C_G$, so bewirkt der Störstrom $I_Z$ eine Drift der Regelgrösse X gemäss dem Störstromzeitintegral.

Ein vollständig anderer Ansatz zur Realisierung höchstohmiger und praktisch driftfreier Messkreise ist unter dem Begriff « vibrating capacitor method » bekannt. Insbesondere ist es aus « Le journal de physique et le radium, bd. 16, août-septembre 1955, pages 695-703 », unter dem Titel « l'électromètre à condensateur vibrant » bekannt, einen Schwingkapazitätsverstärker serie-parallel gegenzukoppeln. Durch die Serie-Parallel-Gegenkopplung wird der hier vorgeschlagene Messkreis ebenfalls extrem hochohmig. Die Wechselspannung an der Schwingkapazität, in ihrer Amplitude durch das auszumessende Signal moduliert, entsprechend der auf die Schwingkapazität aufgebrachten Ladung, wird mittels eines AC-gekoppelten Verstärkers abgegriffen, phasengerecht amplitudendemoduliert und dem zu messenden Signal gegengekoppelt. Wie in dieser Schrift ausgeführt, wird als Verstärker ein relativ schmalbandiger selektiver Verstärker verwendet und die amplitudendemodulierte Spannung vor ihrer Rückführung mittels eines Tiefpassfilters gefiltert. Während mit einem solchen Verfahren, wegen der AC-Kopplung, der Einfluss von DC-Verstärker-Eingangsströmen praktisch verschwindet, ist ein solches Messverfahren relativ langsam. Dies deshalb, weil durch Vorsehen des selektiven Verstärkers höhere Modulationsfrequenzen abgeschnitten werden, zusätzlich noch durch den Tiefpassfilter am Ausgang der Demodulations-Einheit. In der in dieser Schrift dargestellten Realisationsform wird der Messkreis zur Strommessung verwendet, indem die durch einen zu messenden Strom über einer Eingangsimpedanz bewirkte Spannung ermittelt wird. Diese Eingangsimpedanz, ein Hochohmwiderstand von $10^{12}\Omega$ resp. affenfalls eine Kapazität, wird zwischen dem nicht auf Erde geschalteten Anschluss der Schwingkapazität und dem rückgeführten Ausgang der Amplituden-Demodulationseinheit geschaltet. Ein zu messender konstanter Strom ergibt am Hochohmwiderstand eine konstante Spannung, die gemessen wird an einer als Eingangsimpedanz vorgesehenen Kapazität, eine Spannungsrampe entsprechend dem Stromzeitintegral. Das Ausmessen extrem hochohmiger Spannungsquellen, wie mit einer hochwertigen Kapazität als Innenimpedanz, ist mit dem Verfahren in der genannten Schrift nicht vorgesehen.

Darstellung des Erfindung

Die vorliegende Erfindung setzt sich nun zum Ziel, ein Messverfahren zu schaffen, mit welchem einerseits ein schnelles dynamisches Folgevermögen mit Bezug auf ein Messsignal erzielt wird, anderseits dank Erzielen einer extrem hohen Eingangsimpedanz die Messignalquelle praktisch unbelastet bleibt und vom Messkreis her praktisch nicht gleichstrombeaufschlagt wird, ein Verfahren also, womit es möglich wird, die genannten hochohmigen Spannungsquellen auch in Langzeitmessungen zu messen.

Ausgehend vom Verfahren eingangs genannter Art wird dies nun dadurch erreicht, dass einem vom Strom durch die Schwingkapazität abhängigen Signal das rückgeführte, vom ladungsabhängigen, demodulierten Signal abhängige Signal additiv überlagert wird, und dass das resultierende Signal der zu messenden Spannung gegengekoppelt wird.

Dadurch, dass nicht nur wie bei der bekannten « vibrating capacitor »-Methode ein von der auf die Schwingkapazität aufgebrachten Ladung abhängiges Signal dem Messsignal gegengekoppelt wird, sondern, dazu überlagert, ein vom Strom durch besagte Kapazität abhängiges, wird es möglich, das dynamische Verhalten des Messverfahrens gleich gut auszubilden, wie dies bei den Verfahren des Standes der Technik, wie anhand der Fig. 3 bis 6 erläutert worden ist, möglich ist, also z. B. bei « static-capacitor-Methoden ». Betrachtet man nämlich die Schwingkapazität generell als Uebertragungsglied im Regelkreis, so ist ersichtlich, dass zwischen eingangsseitig angelegter Spannung und fliessendem Strom ein Differentialverhalten besteht, zwischen angelegter Spannung und aufgebrachter Ladung Proportionalverhalten, womit durch die erfindungsgemässe Ueberlagerung mit der Schwingkapazität grundsätzlich ein PD-Glied realisiert wird, bezüglich der über dieser Kapazität liegenden Spannung. Betrachtet man anderseits den die Schwingkapazität durchfliessenden Strom als Eingangsgrösse, so ergibt sich durch die erfindungsgemässe Ueberlagerung mit Bezug auf diese Stromeingangsgrösse PI-Verhalten. Das schnelle dynamische Verhalten wird durch Gegenkopplung des stromabhängigen Signalanteils sichergestellt. Zudem wird ersichtlich, dass bei einer Spannung als Eingangsgrösse zur Schwingkapazität der ladungsabhängige Signalanteil — also hier der Proportionalanteil — bereits vor weiteren Uebertragungsstrecken, eine grosse Verstärkung ergibt, bei einem Strom als Eingangsgrösse ebenso, indem das ladungsabhängige Signal als I-Anteil wirkt. Damit werden aber Störgrössen, die an Uebertragungsstrecken eingreifen, die der Schwingkapazität als erste Uebertragungsstrecke nachgeschaltet sind, ausgeregelt.

Obwohl es durchaus möglich ist, das ladungsabhängige und das stromabhängige Signal vor ihrer Ueberlagerung erst je über entsprechend dimensionierte Uebertragungsglieder zu führen, wird vorgeschlagen, dass man das ladungsabhängige, demodulierte Signal als Stromsignal dem Strom durch die Schwingkapazität überlagert. Damit wird der mit Bezug auf die Schwingkapazität ausgangsseitige Strom — da die Ladung auf der Schwingkapazität dem Stromintegral entspricht — mit seinem Zeitintegral verstärkt.

Im weiteren wird das ladungsabhängige Signal vorzugsweise wechselspannungsseitig vor der Demodulation verstärkt. Damit wird, mit der Wechselspannungsverstärkung, ohne Einführung von weiteren DC-Störgrössen ein P- resp. I-Anteil hoher DC-Verstärkung realisiert.

Dadurch, dass man ohne Berücksichtigung der Zeitvarianz der Schwingkapazität bereits den Regelkreis, ohne Ueberlagerung mit dem ladungsabhängigen Signal, für Schnelles Folgeverhalten mit Bezug auf das zu messende Signal auslegt, wird ein schnelles dynamisches Folgeverhalten des Kreises erzielt. Wird dabei der Regelkreis für gutes Folgeverhalten auch mit Bezug auf Signale mit der Schwingfrequenz der Schwingkapazität ausgelegt, so erreicht man, dass, immer noch ohne Erstellung der Ueberlagerung mit dem ladungsabhängigen Signal, am Ausgang des Regelkreises direkt und im Verhältnis 1 : 1 das durch die Kapazitätsschwingung erzeugte Wechselsignal erscheint. Dann wird bevorzugterweise das ladungsabhängige Wechselsignal am gegengekoppelten Regelgrössenausgang des Regelkreises abgegriffen. Mit anderen Worten, dann wird der bereits für gutes Folgeverhalten ausgelegte Regelkreis, der lediglich auf dem Prinzip der Kapazitäts-Strommessung arbeitet, auch dazu verwendet, die Ladung auf der Schwingkapazität zu messen.

Vorzugsweise wird weiter als Eingangsverstärker ein Ladungsverstärker mit der Schwingkapazität mindestens als Teil der Eingangskapazität eingesetzt. Dies entspricht prinzipiell der Schaltung gemäss dem bekannten Verfahren von Fig. 6. Damit wird die Eingangsimpedanz des Messkreises vornehmlich bestimmt durch die um die Verstärkung des offenen Regelkreises erhöhte Impedanz der Schwingkapazität. Unter Berücksichtigung dass die Schwingkapazität als Luft- oder Vakuum-Kapazität ausgebildet werden kann, ist ersichtlich, dass die Kreis-Eingangsimpedanz extrem hoch wird. Beim Einsatz des genannten Ladungsverstärkers wird man das ladungsabhängige, demodulierte Signal als Stromsignal einem Stromsummationspunkt des Ladungsverstärkers zuführen.

Bekannterweise ist es an einer Schwingkondensatoranordnung sehr schwierig und aufwendig, eine Wechselspannung zu realisieren, deren Amplitude genau dann O wird, wenn die extern aufgebrachte Ladung ebenfalls O ist. Dies kann die verschiedensten Gründe haben. Einerseits ist es bekannt, dass auch Schwingkapazitätsplatten aus gleichem Metall, wegen der unterschiedlichen Austrittspotentiale auch ohne externe Ladungszufuhr auf unterschiedlichem Potential liegen, was zu einer Wechselspannungsamplitude ungleich Null führt, anderseits ist die Schwingkapazitätsanordnung als Anordnung bewegter Leiter auch im Umfeld elektrostatischer Felder angeordnet, beispielsweise wegen der Gleichspannungsspeisung des Eingangsverstärkers. Zudem kann kaum verhindert werden, dass bei der Demodulation, trotz nachfolgender Filterung, Signale mit der Modulationsfrequenz, phasenverschoben, mit ebensolchen Signalen über der Schwingkapazität gemischt werden, womit dann die Schwingkapazität als Mischer gleichfrequenter Signale, zu einer DC-Stromquelle wird. Es wird deshalb, weil diese Einflussgrössen nur sehr schwer separierbar sind und ebenso schwer einzeln eliminierbar, vorgeschlagen, die verbleibenden Störgrösseneinflüsse durch Einkopplung eines Wechselfeldes an den Eingang des Kreises zu kompensieren, mit einer der Kapazitätsschwingung entsprechenden Frequenz. Dies ist sehr einfach dadurch möglich, dass im Bereich des Kreiseinganges diesbezüglich auf Abstand ein Stromleiter durchgezogen wird, welcher mit einem Wechselstrom der angegebenen Frequenz beaufschlagt wird. Durch leichte Phasen- und/oder Amplitudenveränderung dieses Wechselstromes ist ein praktisch idealer, stabiler Abgleich möglich.

An dieser Stelle soll bereits auf einen weiteren Vorteil des erfindungsgemässen Verfahrens hingewiesen werden. Hierzu sei nochmals auf Fig. 6 verwiesen. Wird, wie vorgeschlagen, eingangsseitig zum Verstärker 5, als Ladungsverstärker konfiguriert, die Schwingkapazität in Serie zur auszumessenden Quelle geschaltet, so wird eine Spannung, die sich vor Schliessen des Regelkreises auf der Schwingkapazität aufgebaut hat, nach Schliessen des Regelkreises praktisch vollständig abgebaut. Dies ist dann ein ganz wesentlicher Vorteil, wenn eine kapazitive Gleichspannungsquelle ausgemessen werden soll. Wird letztere nämlich in den noch nicht geschlossenen Kreis eingeschaltet, bei dem z. B. die Rückkopplungskapazität des Ladungsverstärkers noch kurzgeschlossen ist, so entlädt sich die Spannungsquelle auf ihre eigene Innenimpedanz und die seriegeschaltete Schwingkapazität. Da die Schwingkapazität in den meisten Fällen kleiner ausgelegt werden kann als die Innenkapazität der Quelle, wird praktisch die gesamte Quellenspannung über der Schwingkapazität liegen. Bei Schliessen des Regelkreises wird diese Spannung auf der Schwingkapazität rasch ausgeregelt, durch Erscheinen eines hohen Wechselsignal. Der dadurch bewirkte Stromstoss durch die Signalquelle und die Schwingkapazität reduziert die Spannung auf der Schwingkapazität zu nahezu Null, wobei die durch den Stromstoss von der Schwingkapazität abgeführte Ladung, wegen der Serieschaltung, auch der Ladung entspricht, die auf die Quelleninnenkapazität aufgebracht wurde. Somit wird die Messung der eingentlichen Quellenspannung möglich, ohne dass letztere sich vorgängig bleibend hätte signifikant auf ihre Innenkapazität entladen können.

Der serie-parallel-gegengekoppelte Messkreis eingangs genannter Art, zur Durchführung des Verfahrens zeichnet sich dadurch aus, dass eine Ueberlagerungseinheit für ein vom Strom durch die Schwingkapazität und das demodulierte, schwingkapazität-ladungsabhängige Signal vorgesehen ist, deren Ausgang am Messkreiseingang der zu messenden Spannung gegengekoppelt ist.

Vorzugsweise wird als Eingangsverstärker ein Ladungsverstärker vorgesehen.

Dann wird als Ueberlagerungseinheit vorzugsweise ein Stromadditionsknoten am Ladungsverstärkereingang eingesetzt.

Vorzugsweise wird die offene Uebertragungsstrecke von Schwingkapazität bis Regelgrössenausgang des Kreises, ohne Zuführung des schwingkapazität-ladungsabhängigen Signals, bereits mit hoher Verstärkung ausgelegt, mindestens bis zur Anregungsfrequenz der Schwingkapazität.

Damit erscheint das ladungsabhängige Signal als Wechselsignalanteil am Ausgang des nun geschlossenen Regelkreises. Die Schwingkapazität wirkt mit Bezug auf die über ihr liegende Spannung als Amplitudenmodulator. Vorzugsweise wird dem Regelgrössenausgang des Kreises ein Wechselspannungsvertärker nachgeschaltet, dessen Ausgang auf die Demodulationseinheit geführt ist, letztere zur Amplitudenmodulation.

Es hat sich nun gezeigt, dass die Demodulation auf verschiedene Arten durchgeführt werden kann, beispielsweise durch Einsatz eines Analogmultiplikators, woran das am Regelgrössenausgang abgegriffene Wechselsignal mit einem gleichfrequenten, phaseneinstellbaren Referenz-Wechselsignal multipliziert wird. Da jedoch, wie bereits erwähnt worden ist, die Spannung über der Schwingkapazität auf praktisch Null ausgeregelt wird, zeigt es sich, dass weniger die Amplitudeninformation von Bedeutung ist, als dass vielmehr eine Regelung mit Bezug auf die Phase zwischen abgegriffener Wechselspannung und Referenzwechselspannung einsetzt, d. h. die Phase zwischen Referenz und abgegriffenem Signal wird auf $\pi/2$ geregelt. Aus dieser Erkenntnis, nämlich dass bei genügender Verstärkung des abgegriffenen Wechselsignalanteils auf Phasenlage zwischen Schwingkapazitätsspannung und Referenzwechselspannung geregelt wird, wird vorzugsweise dem Regelgrössenausgang über ein Hochpassfilter ein Pulsformer nachgeschaltet, dessen Ausgangssignal der Demodulationseinheit zugeführt ist, wobei letztere eine EX-OR-Einheit umfasst, deren einem Eingang besagtes Ausgangssignal deren anderem Eingang ein Phasenreferenzsignal zugeführt ist, und dass der Ausgang der EX-OR-Einheit ein bipolares DC-Signal umschaltet. Auf diese Art und Weise wird lediglich die Phaseninformation von Schwingkapazitäts-Wechselsignal mit Bezug auf ein Phasenreferenzsignal ausgewertet, und beispielsweise mit einem Analogschalter, entsprechend der relativen Phasenverschiebung besagter signale +/-DC-Signale umgeschaltet. Der durch das Umschalten der bipolaren DC-Signale erzeugte DC-Anteil ist dann das dem vom Strom durch die Schwingkapazität abhängigen Signal überlagerte, schwingkapazitätsladungsabhängige Signal.

Um eine extrem gute Entkopplung des Messkreises von Anregungssignalen für die Schwingkapazität zu erzielen, wird weiter vorgeschlagen, dass die Schwingkapazität über eine schwingende Luftsäule angeregt wird. Vorzugsweise wird dies so realisiert, dass eine Platte der Schwingkapazität auf einer Schwingmembrane montiert ist, die über einen Luftleiter, wie ein Rohr, von einem abgelegenen Schwingungsgeber, wie einem elektromagnetischen Geber, angeregt ist. Als elektromagnetischer Geber kann beispielsweise ein Lautsprecher eingesetzt werden.

Zum Abgleich eines verbleibenden Störgrösseneinflusses wird weiter vorgeschlagen, im Bereich des Eingangsverstärkers einen Stromleiter durchzuführen, der mit einem Wechselstrom der Schwingkapazität-Anregungsfrequenz beaufschlagt ist.

Das vorgeschlagene Verfahren sowie der vorgeschlagene serie-parallel gegengekoppelte Messkreis eignen sich, wie erwähnt, vorzüglich zur Messung von Spannungsquellen mit höchstohmigen Innenimpedanzen, wie von kapazitiven DC-Spannungsquellen. Als solche Quellen sind beispielsweise Kontaktspannungen an hochisolierenden Stoffen, wie hochpolymeren Isolatoren, z. B. Teflon, zu nennen.

## Kurzbeschreibung der Figuren

Die Erfindung wird anschliessend beispielsweise anhand von weiteren Figuren erläutert:

Es zeigen:

Figur 7 ein Funktionsblockdiagramm einer bevorzugten Ausführungsform der erfindungsgemässen Messkreises,

Figur 8a ein Regelkreis-Blockschaltbild des Messkreises gemäss Fig. 7,

Figur 8b ein Teil des Blockschaltbildes gemäss Fig. 8a, in anderer Darstellungsweise,

Figur 9 ein detailliertes Funktionsblockdiagramm der Anordnung gemäss Fig. 7.

## Beschreibung der Einzelfiguren

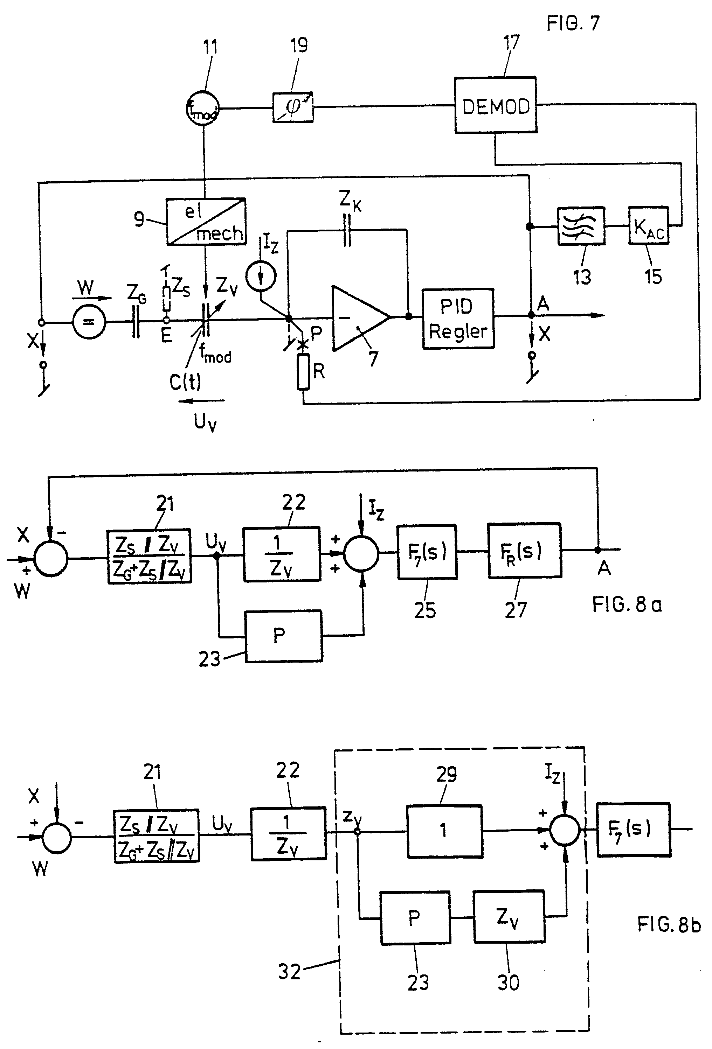

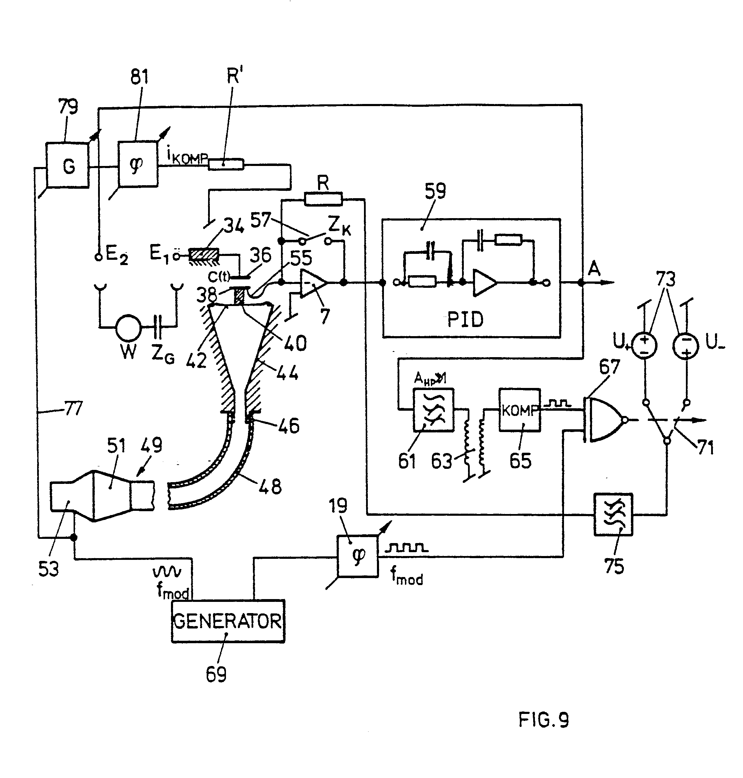

Gemäss Fig. 7 wird die auszumessende Führungssignalquelle W mit ihrer rein kapazitiv dargestellten Innenimpedanz $Z_G$ auf den Messverstärkerkreis-Eingang E geschaltet. Ein in invertierenden Schaltungskonfiguration als Ladungsverstärker beschalteter Operationsverstärker 7 weist als Eingangsimpedanz eine abstandsmodulierbare Schwingkapazität C(t) auf und als Rückkopplungsimpedanz $Z_K$ ebenfalls eine Kapazität. Dem Eingangsverstärker 7 ist ein nichtinvertierender PID-Regel nachgeschaltet, dessen Ausgang auf den zweiten Pol der auszumessenden Quelle, aus Führungssignalquelle W und Innenimpedanz $Z_G$ bestehend, geführt ist. Die Schwingkapazität C(t) wurde als Luftkapazität realisiert, mit einer festen Platte und einer schwingenden Platte, z. B. der Anschluss der schwingenden Platte ist auf den Verstärker 7 geführt. Die Schwingkapazität C(t) wird generell durch einen elektrisch mechanischen Wandler 9 in Schwingung versetzt. Eingangsseitig wird der elektromechanische Wandler 9 von einem Generator 11 mit der Frequenz $f_{mod}$ angeregt. Elektromechanische Wandler, um die eine metallische Platte einer Schwingkapazität anzuregen, sind an und sich bekannt. Eine bevorzugte Anregungsart soll anhand von Fig. 9 noch beschrieben werden. Der Ausgang A des Messverstärkerkreises wird einerseits zur Auswertung des Messignals abgegriffen, andererseits, gemäss Fig. 7, über ein Bandpassfilter 13, abgestimmt auf die Modulationsfrequenz $f_{mod}$ sowie einen Wechselspannungsverstärker 15 auf den einen Eingang einer Demodulationseinheit 17 geführt. Hier wird somit der Demodulationseinheit das mit der Spannung $U_v$ über der Schwingkapazität amplitudenmodulierte Signal der Trägerfrequenz $f_{mod}$ zugeführt. Dem zweiten Eingang der Demodulationseinheit 17 ist über ein vorzugsweise einstellbares Phasenglied 19 der Ausgang des Modulationsgenerators 11 als trägerfrequentes Referenzsignal zugeführt. Als Demodulationseinheit 17 zur AM-Demodulation kann dabei ein handelsüblicher analogmultiplikator verwendet werden. Die Ausgangsspannung der Demodulationseinheit wird durch einen Hochohmwiderstand R in einen Strom gewandelt, der dem Stromsummationspunkt der Verstärkers 7 zugeführt ist.

In fig. 7 stellt die gestrichelt eingetragene Impedanz $Z_S$ die nicht vernachlässigbare Streuimpedanz des Eingangs E aus Masse dar.

In Fig. 8a ist das Reglerblockdiagramm der Anordnung gemäss Fig. 7 dargestellt. Vorerst ist zu berücksichtigen, dass der Regelkreis gemäss Fig. 7 ohne Ueberlagerung des Demodulationseinheits-Ausgang-Signales mit dem die Schwingkapazität C(t) durchfliessenden Strom am Stromadditionsknoten des Verstärkers 7, d. h. bei Unterbrechung der Zuführleitung, wie in Fig. 7 bei P angedeutet, durch entsprechende Dimensionierung der Frequenzgänge von Verstärker 7 und PID-Regler so ausgelegt wird, dass am Regelgrössenausgang A die Regelgrösse X möglichst exakt der Summe der Spannungen folgt, die an den Verstärkereingang des Verstärkers 7 angelegt ist. Die genannten Frequenzgänge werden so ausgelegt, dass sowohl ein schnelles wie auch exaktes Folgeverhalten mit Bezug auf die genannte Eingangsspannungs-Summe erfolgt. Die genannte Summe setzt sich zusammen aus der Führungsgrösse W und der Spannung $U_v$ über der Schwingkapazität C(t).

Am Ausgang A des Messkreises, immer noch bei unterbrochener Zuführung bei P, erscheint somit erstens das Führungssignal W, zweitens ein durch den Störstrom $I_z$ bewirkter, mit dessen Zeitintegral mit der Zeit ansteigender Spannungsanteil, entsprechend dem Integral des Stromes $I_z$ an der Schwingkapazität C(t) und der Innenimpedanz $Z_G$ der auszumessenden Quelle, und drittens ein Wechselspannungssignal der Frequenz $f_{mod}$, dessen Amplitude mit der über der Schwingkapazität C(t) liegenden Spannung moduliert ist. Durch die Demodulation an der Demodulationseinheit 17 wird ausgangsseitig besagter Einheit eine Spannung erhalten, die proportional zu der über der Schwinkapazität C(t) vorherrschenden Spannung ist. Durch den Hochohmwiderstand R wird somit ein Strom an den Eingang des Verstärkers 7 eingeführt, der, wie erwähnt, proportional zu der über der Schwingkapazität C(t) liegenden Spannung $U_v$ ist, d. h. proportional zu Ladung auf der Schwingkapazität. Dies führt nun auf das Regelblockdiagramm gemäss Fig. 8a.

Die Differenz von Führungsgrösse W und Regelgrösse X wird mit einer ersten Uebertragungsfunktion gemäss Block 21 in die Spannung über der Schwingkapazität C(t), hier generell als Impedanz $Z_v$ bezeichnet, also die Spannung $U_v$ übertragen. Die Uebertragungsfunktion im Block 21 ergibt sich aus dem Spannungsteiler, einerseits aus der Innenimpedanz $Z_G$, andererseits aus der Parallelschaltung der Streuimpedanz $Z_S$ und der Impedanz $Z_v$ der Schwingkapazität C(t). Die über der Schwingkapazität C(t) sich ergebende

Spannung $U_V$ wird einerseits durch die Impedanz $Z_V$ der Schwingkapazität in den die Schwingkapazität durchfliessenden Strom gewandelt, der gemäss Fig. 7 dem Stromsummationsknoten des Verstärkers 7 zugeführt wird — virtuell auf Erdpotential — andererseits wird aber durch Abgreifen der der Spannung über der Schwingkapazität C(t) proportionalen Wechselspannung am Ausgang A des Messkreises, deren Demodulation und der Einkopplung eines dem Demodulationsresultat proportionalen Stromes über den Hochohmwiderstand R von Fig. 7 an den Stromsummationsknoten, diesem Punkt, wie in Fig. 8a ersichtlich, ein zusätzlicher Strom zugeführt, der proportional ist zur Spannung $U_V$, die über der Schwingkapazität C(t) liegt. Somit wird dem Stromsummationsknoten des Verstärkers 7 einserseits der Strom durch die Schwingkapazität C(t) zugeführt, anderseits ein Strom, der proportional zur Spannung über der Schwingkapazität C(t) ist, also der proportional zur Ladung auf besagter Schwingkapazität ist.

Die Uebertragungsfunktion im Block 22 von Fig. 8a zwischen Spannung $U_V$ und Schwingkapazität durchfliessendem Strom entspricht somit dem Kehrwert der Impedanz $Z_V$ der Schwingkapazität C(t), somit einem Differentialglied, denn es gilt allgemein
$1/Z_V = 1 + sT_V/R_V$ mit $R_V$ als Streuwiderstand und $T_V = R_V C_V$, weiter mit $C_V$ als Mittelwert der Schwingkapazität C(t). Die Uebertragungsfunktion im Block 23 ist ein Proportionalglied. Die Summe der dem Stromsummationsknoten des Verstärkers 7 gemäss Fig. 7 zugeführten Ströme wird wiederum gemäss Fig. 8a über einen weiteren Block 25 der Uebertragungsfunktion $F_7(s)$, entsprechend der Uebertragungsfunktion des mit $Z_K$ gegengekoppelten Stromverstärkers 7 und an einem weiteren Block 27 mit der Uebertragungsfunktion $F_R(s)$, entsprechend derjenigen des PID-Reglers von Fig. 7 verstärkt, der Ausgang A des Blockes 27 wird als Regelgrösse X vorzeichenrichtig auf den Eingang rückgeführt.

Die Wirkung der parallelen Blockstruktur in den Blöcken 22, 23 gemäss Fig. 8a wird nach einer formellen Umstrukturierung besser ersichtlich. Deshalb ist in Fig. 8b der Block 22 vor die Verzweigstelle der Parallelstruktur geschoben. Die Parallelstruktur ergibt sich damit aus einem Block 29 einerseits, mit Einheits-Uebertragungsfunktion für den die Schwingkapazität C(t) von Fig. 7 durchfliessenden Strom, anderseits, parallel dazu, aus dem Block 23, dem Proportionalglied, und, in Serie dazu, einem weiteren Block 30 mit einer Uebertragungsfunktion entsprechend der Impedanz $Z_V$ der Schwingkapazität C(t). Aus dieser Darstellung ist nun ersichtlich, dass mit der erfindungsgemässen Parallelstruktur, an welcher dem Verstärker 7 einerseits der die Schwingkapazität C(t) durchfliessende Strom zugeführt wird und zusätzlich, hierzu überlagert, ein Strom, der proportional ist zur Ladung auf der Schwingkapazität C(t), ein Block 32, hoher Verstärkung geschaffen wird. Dabei ist zu berücksichtigen, dass sich, ohne Ueberlagerung des ladungsproportionalen Stromes, also bei Unterbruch bei P von Fig. 7, die Parallelstruktur 32 auf die Einheits-Uebertragungsfunktion in Block 29 reduziert.

In der Darstellung gemäss Fig. 8b mit der Eingangsgrösse $i_v$, d. h. dem die Schwingkapazität C(t) durchfliessenden Strom als Eingangsgrösse zum Block 32, ergibt sich dieser Block 32 zu einem PI-Glied, sehr hoher Gleichstromverstärkung, unter Berücksichtigung, dass die Impedanz $Z_V$ der Schwingkapazität C(t) derjenigen einer sehr hochwertigen Kapazität entspricht. Damit wird aber ersichtlich, dass die Störgrösse $I_Z$, wie in den Fig. 8a und 8b eingetragen, beispielsweise entsprechend dem Eingangsstrom des Verstärkers 7 erst nach dem Block 32 hoher Verstärkung eingreift, und weiter, dass diese Störgrösse $I_Z$ am Kreis von Fig. 7 mit geschlossener Rückführung bei P praktisch vollständig ausgeregelt wird.

In Fig. 9 ist schematisch eine bevorzugte Realisationsform der Kreises gemäss Fig. 7 dargestellt. An den beiden Eingangsklemmen $E_1$, $E_2$ des Kreises wird die auszumessende reale Quelle mit der idealen Spannungsquelle W als Führungssignalquelle und der Innenimpedanz $Z_G$ aufgeschaltet. Der Eingang $E_1$ ist mit Bezug auf Masse, wie bei 34 dargestellt, hochisoliert auf die eine Platte 36 der Schwingkapazität C(t) geführt. Die zweite Platte 38 der Schwingkapazität C(t) ist mit einem hochisolierenden Sockel 40 auf einer an ihrem Umfang gelagerten Kreismembrane, beispielsweise einer Lautsprechermembrane 42, gelagert. Die Membrane 42 liegt am Ausgang eines sich konisch erweiternden Rohres 44, mit einem Schlauchanschluss 46, über welchen ein flexibler Schlauch 48 gestülpt ist, dessen zweiter Anschluss 49 über ein Anpasstück 51 auf einen Lautsprecher 53 geführt ist.

Der Schlauch 48 kann dabei relativ lang, beispielsweise 1m lang sein. Durch Anregung des Lautsprechers 53 wird die Luftsäule im Schlauch 48 in Schwingung versetzt und regt via Membrane 42 die schwingende Platte 38 der Schwingkapazität C(t) an. Dabei ist jedoch eine optimale Entkopplung zwischen elektromagnetischer Lautsprecheranregung und Eingang des Messkreises resp. der Schwingkapazitätsanordnung sichergestellt. Die schwingende Platte 38 der Schwingkapazität C(t) ist über eine flexible Litze 55 auf den Stromsummationsknoten des Verstärkers 7 geführt, dessen Rückkopplungsimpedanz lediglich aus einem hochisolierenden Reed-Schalter 57 besteht, der, geöffnet, eine kleine Kapazität $C_K$ darstellt resp. $Z_K$, unter Berücksichtigung des Schalter-Isolationswiderstandes. Der Ausgang des Verstärkers 7 ist auf den PID-Regler 59 geführt, dessen Ausgang, dem Ausgang A von Fig. 7 entsprechend, auf die Eingangsklemme $E_2$ rückgeführt ist. Dem Ausgang A des PID-Reglers 59 ist nun im Unterschied zu Fig. 7 kein Bandpass-, sondern ein Hochpassfilter 61 zugeschaltet, dessen Verstärkung oberhalb seiner Grenzfrequenz wesentlich grösser als 1 ist. Als Grenzfrequenz wird vorzugsweise die Anregungsfrequenz $f_{mod}$ der Schwingkapazität C(t) gewählt. Durch Vorsehen eines Hochpassfilters 61, anstelle eines Bandpassfilters 13, gemäss Fig. 7, werden alle Frequenzen oberhalb der Anregungsfrequenz $f_{mod}$ übertragen, nach den Gesetzen der Amplitudenmodulation somit alle Frequenzanteile der über der Schwingkapazität C(t) liegenden Spannung $U_V$. Der Ausgang des verstärkenden Hochpassfilters 61 wird über einen transformatorischen Uebertrager 63 auf den Eingang eines Nulldurchgangkomparators 65 geführt. Der Uebertrager 63 sorgt für eine perfekte DC-Entkopplung zwischen Ausgang des Hochpassfilters 61 und Eingang des Komparators 65. Der Komparator 65 gibt somit an seinem Ausgang einen Impulszug ab, der Frequenz $f_{mod}$, mit einer vorgegebenen Pulsamplitude, beispielsweise auf TTL-Niveau. Seine Phasenlage entspricht bis auf eine übertragungsstreckenbedingte feste Verschiebung derjenigen der Schwingkapazitäts-Wechselspannung. Dieses Pulssignal wird einem EX-OR-Tor 67 zugeschaltet. An den zweiten Eingang des EX-OR-Tores 67 wird ein Demodulations-Phasenreferenzsignal zugeführt. Ein Generator 69 regt einerseits mit einem sinusförmigen Signal der Frequenz $f_{mod}$ den Lautsprecher 53 und damit die Schwingkapazität C(t) an und gibt über ein vorzugsweise einstellbares Phasenglied 19 den Refrenzphasen-Impulszug, vorzugsweise mit TTL-Amplitude und mit einer Frequenz $f_{mod}$ an das EX-OR-Tor ab. Der Ausgang des EX-OR-Tores 67 schaltet einen Umschalter 71 um, zwischen DC-Spannungssignalwerten $U_+$, $U_-$ gleicher Amplitude und umgekehrter Polarität. Diese Spannungswerte $U_+$ und $U_-$ werden vorzugsweise durch zwei einstellbare Spannungsquellen 73 erzeugt. Der Ausgang des Umschalters 71 wird auf einen Tiefpassfilter 75 geführt, dessen Ausgang über den Hochohmwiderstand R dem Strom-Summationspunkt des Verstärkers 7 zugeführt ist. Die Phase $\varphi$ am Phasenglied 19 wird so eingestellt, dass bei offener Rückführung entsprechend Unterbruch bei P von Fig. 7, die beiden Eingangssignale zum EX-OR-Tor 67 in Phase resp. in Gegenphase sind. Durch Vorsehen des Hochpasses 61 anstelle eines Bandpasses ist die Auslegung des Tiefpasses 75 von der Stabilität her betrachtet, weniger eingeschränkt.

Vom Generator 69 wird über eine Leitung 77 das sinusförmige Lautsprecher-Anregungssignal über ein Verstärker-Abschwächerglied 79 und ein weiteres, vorzugsweise einstellbares Phasenglied 81, weiter ein Widerstandselement R', in einen Strom $i_{KOMP}$ gewandelt, mit der Frequenz $f_{mod}$, der im Bereich des Eingangs zum Verstärker 7 durchgeführt wird. Vermutlich vornehmlich durch induktive Einkopplung ergibt sich damit die Möglichkeit, mit Amplitude und/oder Phase des Stromes $i_{KOMP}$ noch verbleidende Störgrösseneinflüsse am Messkreis zu kompensieren. Derartige Störgrössen können sein :

Eine Potentialdifferenz zwischen den Platten des Schwingkondensators, die unabhängig von extern aufgebrachter Ladung ist und sich aus unterschiedlichen Kontaktpotentialen zwischen den Platten und der dazwischenliegenden Luft ergibt.

Kleine Wechselströme, die am Eingang des Verstärkers 7 dadurch entstehen, dass die bewegte Kapazitätsplatte 38 als bewegter Leiter zu betrachten ist, der sich in einem felderfüllten Raum bewegt, z. B. wegen der Speisungszuführungen zum Verstärker 7.

Ueber den Hochohmwiderstand R rückgeführte, nicht vollständig ausgefilterte Wechselstromkomponenten der Frequenz $f_{mod}$, die an der Schwingkapazität mit Schwingkapazität-Wechselsignalen gemischt werden.

Mit einem Messverstärkerkreis gemäss Fig. 9 wurden vorerst ohne Abgleich mit dem Wechselstrom $i_{KOMP}$, bei der Ausmessung von Signalquellen mit einer Innenimpedanz :

$$R_G \cong 10^3 T\Omega$$
$$C_G \cong 5pF$$

eine über 24 Stunden gemessene Drift von ca. 100 mV erzielt, was einem Reststrom in der Grössenordnung von 10aA entspricht. Derartige Resultate waren jedoch nur nach sehr zeitaufwendigen Veränderungen der geometrischen Verhältnisse von Kapazitätsplatten, Abschirmungen etc. am Eingang des Verstärkers möglich sowie der Plattenoberflächen. Auf Anhieb waren die Resultate um ca. einen Faktor 10 schlechter. Mit dem Abgleich mittels des Wechselstromes $i_{KOMP}$ sind hingegen auf Anhieb und ohne weiteres reproduzierbar, Resultate erzielbar, die einem Reststrom in der genannten Grössenordnung und besser entsprechen, also unter $10^{-17}$ A. Der geometrische Aufbau der Schwingkapazität ist dann unkritisch, was z. B. die Plattenparallelität anbelangt, kritisch bleibt jedoch vermutlich der Isolationswiderstand der Durchführung 34. Diese Durchführung 34 gemäss Fig. 9 wurde aus Saphir hergestellt.

Wie aus der Betrachtung von Fig. 8a ersichtlich, wird die über der Schwingkapazität C(t) liegende Spannung $U_V$ bis auf einen sehr kleinen Wert ausgeregelt. Dies führt zu dem nachfolgend zu beschreibenden, sehr vorteilhaften Phänomen :

Wird die auszumessende reale Quelle mit der Führungsquelle W und der Innenimpedanz $Z_G$ bei kurzgeschlossener Gegenkopplungsimpedanz $Z_K$ in den Kreis, durch Einstecken an den Anschlüssen $E_1$ und $E_2$ eingeschaltet, so lädt die Führungssignalquelle W die seriegeschalteten Kapazitäten der Innenimpedanz $Z_G$ und der Schwingkapazität C(t) auf. Wegen der Serieschaltung dieser beiden Impedanzen fliesst dabei auf beide Impedanzen dieselbe Ladung auf. Wird, wie dies ohne weiteres möglich ist, der Ruhewert der Schwingkapazität C(t) wesentlich kleiner gewählt als der Kapazitätswert der Innenimpedanz $Z_G$, so liegt mithin in diesem Zustand praktisch die gesamte Spannung W über der Schwingkapazität C(t). Wird nun durch Oeffnen des Rückkopplungsschalters am Ladungsverstärker der Messkreis in Betrieb gesetzt, so wird die über der Schwingkapazität C(t) liegende Spannung rasch auf einen kleinen Wert reduziert. Durch diesen Spannungs- resp. Ladungsabbau und wegen der Serieschaltung der beiden Impedanzen $Z_G$ und $C(t)$ wird dabei auch die Spannung auf der Innenimpedanz $Z_G$, die sich vorgängig zum Oeffnen des Schalters 57 von Fig. 9 dort aufgebaut hat, rasch wieder abgebaut. Damit ergibt sich aber die Möglichkeit, die auszumessende Quelle ohne weitere Massnahmen an den Anschlüssen $E_1$, $E_2$ in den Kreis einzuschalten, dann den Rückkopplungsschalter 57, entsprechend $Z_K$, zu öffnen und es erscheint am Ausgang A die praktisch unverfälschte Spannungsgrösse entsprechend W. Damit wird es möglich, nicht nur das dynamische Verhalten dr Führungssignalquelle W zu messen, sondern auch mit recht guter Genauigkeit ihren Absolutwert.

Gewerbliche Verwertbarkeit

Das vorgeschlagene Verfahren und der vorgeschlagene Messkreis können grundsätzlich überall dort eingesetzt werden, wo es gilt, Spannungsquellen auszumessen, welche extrem hohe Innenimpedanzen aufweisen, deren Innenimpedanzen z. B. hochwertige Kapazitäten sind, d. h. bei denen die eigentliche Spannungsquelle galvanisch nicht abgegriffen werden kann.

**Patentansprüche**

1. Verfahren zum Messen einer Gleichspannung oder einer sich langsam verändernden Spannung (W) über einer oder in Serie zu einer sehr hochohmigen Impedanz ($Z_G$), insbesondere einer hochwertigen Kapazität ($C_G$), oder einer sehr hochohmigen Spannungsquelle ($WZ_G$) mittels eines serie-parallel-gegengekoppelten Verstärkerkreises, der einen Eingangsverstärker (7) mit vorgeschalteter Schwingkapazität ($C(t)$), deren Kapazitätswert über eine Schwingung mit vorgegebener fester Frequenz steuerbar ist, aufweist, die durch die zu messende Spannung (W) aufgeladen wird, so dass an der Schwingkapazität ($C(t)$) eine mit der Aufladung amplitudenmodulierte Wechselspannung entsteht, die ausgefiltert und zu einem amplitudenabhängigen Signal demoduliert wird, das in den Eingangskreis rückgeführt wird, dadurch gekennzeichnet, dass einem von Strom durch die Schwingkapazität ($C(t)$) abhängigen Signal das rückgeführte, vom ladungsabhängigen, demodulierten Signal abhängige Signal additiv (P) überlagert wird, und dass das resultierende Signal (X) der zu messenden Spannung (W) gegengekoppelt wird.

2. Verfahren nach Anspruch 1, dadurch gekennzeichnet, dass man das ladungsabhängige, demodulierte Signal als Stromsignal dem Strom durch die Schwingkapazität ($C(t)$, 36, 38) überlagert.

3. Verfahren nach Anspruch 1 oder 2, dadurch gekennzeichnet, dass man das ladungsabhängige Signal wechselspannungsseitig vor der Demodulation verstärkt.

4. Verfahren nach einem der Ansprüche 1 bis 3, dadurch gekennzeichnet, dass man, ohne Berücksichtigung der Zeitvarianz der Schwingkapazität, bereits den Regelkreis ohne Ueberlagerung mit dem ladungsabhängigen Signal, für schnelles Folgeverhalten mit Bezug auf das zu messende Signal (W) auslegt.

5. Verfahren nach Anspruch 4, dadurch gekennzeichnet, dass man den Regelkreis für gutes Folgeverhalten mit Bezug auf Signale mit der Schwingfrequenz ($f_{mod}$) der Schwingkapazität ($C(t)$, 36, 38) auslegt.

6. Verfahren nach Anspruch 5, dadurch gekennzeichnet, dass man das ladungsabhängige Wechselspannungssignal am gegengekoppelten Regelgrössenausgang (A) des Verstärkerkreises abgreift.

7. Verfahren nach einem der Ansprüche 1 bis 6, dadurch gekennzeichnet, dass man als Eigangsverstärker einen Ladungsverstärker (7) einsetzt.

8. Verfahren nach Anspruch 7, dadurch gekennzeichnet, dass man das ladungsabhängige, demodulierte Signal als Stromsignal einem Stromsummationspunkt (P) des Ladungsverstärkers (7) zuführt.

9. Verfahren nach einem der Ansprüche 1 bis 8, dadurch gekennzeichnet, dass man verbleibende Störgrösseneinflüsse durch Einkopplung eines in Amplitude (79) und/oder Phase (81) einstellbaren Wechselfeldes an den Eingang des Verstärkerkreises kompensiert, mit einer derjenigen der Kapazitätsschwingung entsprechenden Frequenz ($f_{mod}$).

10. Serie-parallel-gegengekoppelter Messkreis zur Durchführung des Verfahrens nach einem der Ansprüche 1 bis 9, mit einem Eingangsverstärker (7), mit vorgeschalteter Schwingkapazität ($C(t)$, 36, 38) sowie nachgeschalteter Demodulationseinheit (13, 15, 17 ; 61, 63, 65, 67, 73, 71, 75) für das schwingkapazität-bewirkte Wechselsignal, wobei ein vom Ausgangssignal der Demodulationseinheit abhängiges Signal auf den Eingang des Messkreises zurückgeführt ist, dadurch gekennzeichnet, dass eine Ueberlagerungseinheit (Summationspunkt von 7) für ein vom Strom durch die Schwingkapazität ($C(t)$, 36, 38) und das demodulierte, schwingkapazität-ladungsabhängige Signal vorgesehen ist, deren Ausgang (A) am Messkreiseingang ($E_2$) der zu messenden Spannung (W) gegengekoppelt ist.

11. Serie-parallel-gegengekoppelter Messkreis nach Anspruch 10, dadurch gekennzeichnet, dass der Eingangsverstärker ein Ladungsverstärker (7) mit der Schwingkapazität ($C(t)$) mindestens als Teil seiner Eingangsimpedanz ($Z_G$, $Z_S$, $Z_V$) ist.

12. Serie-parallel-gegengekoppelter Messkreis nach Anspruch 10, dadurch gekennzeichnet, dass die Ueberlagerungseinheit ein Stromadditionsknoten am Ladungsverstärkereingang ist.

13. Serie-parallel-gegengekoppelter Messkreis nach einem der Ansprüche 10 bis 12, dadurch gekennzeichnet, dass die offene Uebertragungsstrecke von Schwingkapazität bis Regelgrössenausgang (A) des Kreises, ohne Zuführung des schwingkapazität-ladungsabhängigen Signals, bereits hohe Verstärkung aufweist, mindestens bis zur Anregungsfrequenz ($f_{mod}$) der Schwingkapazität (C(t), 36, 38).

14. Serie-parallel-gegengekoppelter Messkreis nach Anspruch 13, dadurch gekennzeichnet, dass dem Regelgrössenausgang (A) ein Wechselspannungsverstärker (15, 61) nachgeschaltet ist, dessen Ausgang auf die Demodulationseinheit (17) geführt ist.

15. Serie-parallel-gegengekoppelter Messkreis nach Anspruch 13, dadurch gekennzeichnet, dass dem Regelgrössenausgang (A) über ein Hochpassfilter (61) ein Pulsformer (65) nachgeschaltet ist, dessen Ausgangssignal der Demodulationseinheit zugeführt ist, wobei letztere eine EX-OR-Einheit (67) umfasst, deren einem Eingang besagtes Ausgangssignal, deren anderem Eingang ein Phasenreferenzsignal zugeführt ist, und dass der Ausgang der EX-OR-Einheit (67) ein bipolares DC-Signal (73) umschaltet.

16. Serie-parallel-gegengekoppelter Messkreis nach einem der Ansprüche 10 bis 15, dadurch gekennzeichnet, dass die Schwingkapazität über eine schwingende Luftsäule (53, 48, 52) angeregt wird.

17. Serie-parallel-gegengekoppelter Messkreis nach Anspruch 16, dadurch gekennzeichnet, dass die eine Platte (38) der Schwingkapazität auf einer Schwingmembrane (42) montiert ist, die über einen Luftleiter (48) von einem abgelegenen Schwingungsgeber (53), wie einem elektromagnetischen Geber, angeregt ist.

18. Serie-parallel-gegengekoppelter Messkreis nach einem der Ansprüche 10 bis 17, dadurch gekennzeichnet, dass zum Abgleich eines verbleibenden Störgrösseneinflusses, im Bereich des Eingangsverstärkers (7) ein Stromleiter (77) durchgeführt ist, der mit einem Wechselstrom ($i_{KOMP}$) der Schwingkapzitätsanregungsfrequenz ($f_{mod}$) beaufschlagt ist, der in Phase und-/oder Amplitude einstellbar ist.

**Claims**

1. Process for measuring a D.C. voltage or slowly changing voltage (W) across or in series to a very high ohmic impedance ($Z_G$), in particular a high quality capacitance ($C_G$), or a highly resistive voltage source ($WZ_G$) by means of a series-parallel negative feedback amplifier circuit, which comprises an input amplifier (7) with upstream vibrating capacitance (C(t), the capacitance value of which is controllable via a preset fixed-frequency vibration and which is charged by the voltage (W) to be measured, thereby creating an A.C. voltage at the vibrating capacitance (C(t)) which is amplitude-modulated by the charge, the A.C. voltage being filtered out and demodulated to give an amplitude-dependent signal, which is fed back into the input circuit, characterised in that the feedback signal which is dependent upon the charge-dependent, demodulated signal is additively (P) superimposed upon a signal dependent upon the current through the vibrating capacitance (C(t)), and in that the resulting signal (X) is negative feedback to the voltage (W) to be measured.

2. Process according to claim 1, characterised in that the charge-dependent, demodulating signal is superimposed as a current signal upon the current through the vibrating capacitance (C(t), 36, 38).

3. Process according to claim 1 or 2 characterised in that the charge dependent signal is amplified on the A.C. voltage side prior to demodulation.

4. Process according to one of claims 1 to 3, characterised in that, without taking into account the time variant of the vibrating capacitance, the control circuit is designed for fast following response with regard to the signal (W) to be measured, even without superimposing the charge dependent signal.

5. Process according to claim 4, characterised in that the control circuit is laid out for good follower behaviour with respect to signals on the vibration frequency ($f_{mod}$) of the vibrating capacitance (C(t), 36, 38).

6. Process according to claim 5, characterised in that the charge dependent A.C. voltage signal is sampled at the opposing variable output (A) of the amplifier circuit.

7. Process according to one of claims 1 to 6, characterised in that a charge amplifier (7) is used as input amplifier.

8. Process according to claim 7, characterised in that the charge dependent, demodulated signal is passed as a current signal to a current summation point (P) of the charge amplifier (7).

9. Process according to one of claims 1 to 8, characterised in that influence from residual disturbance variables is compensated for by coupling an amplitude (79) and/or phase (81) adjustable alternating field into the input of the amplifier circuit, at a frequency ($f_{mod}$) corresponding to that of the capacitance vibration.

10. Negative feedback series-parallel measuring circuit for carrying out the process according to one of claims 1 to 9, comprising an input amplifier (7) with upstream vibrating capacitance (C(t), 36, 38) and downstream demodulation unit (13, 15, 17, 61, 63, 65, 67, 73, 71, 75) for the A.C. signal produced by the vibrating capacitance, with a signal dependent upon the output signal of the demodulation unit being fed back to the input of the measuring circuit, characterised in that a heterodyne unit (summation point of 7) is provided for a signal dependent from the current through the vibrating capacitance (C(t), 36, 38) and for the demodulated vibrating-capacitance (C(t), 36, 38) and for the demodulated vibrating-capacitance-charge-dependent signal, the output (A) of which is opposing the voltage (W) to be measured at the measuring circuit input ($E_2$).

11. Negative feedback series-parallel measuring circuit according to claim 10, characterised in that the input amplifier is a charge amplifier (7) with the vibrating capacitance (C(t)) being at least a part of its input impedance ($Z_G$, $Z_S$, $Z_V$).

12. Negative feedback series-parallel measuring circuit according to claim 10, characterised in that the heterodyne unit is a current addition node at the input of the charge amplifier.

13. Negative feedback series-parallel measuring circuit according to one of claims 10 to 22, characterised in that the open transfer loop from vibrating capacitance to variable output (A) of the circuit, without feeding the vibrating-capacitance-charge-dependent signal, already has high amplification, at least up to the excitation frequency ($f_{mod}$) of the vibrating capacitance (C(t), 36, 38).

14. Negative feedback series-parallel measuring circuit according to claim 13, characterised in that an A.C. voltage amplifier (15, 61) is arranged downstream of the controlled variable output (A), the output of which is passed to the demodulation unit (17).

15. Negative feedback series-parallel measuring circuit according to claim 13, characterised in that a pulse former (65) is arranged downstream of the controlled variable output (A) via a highpass filter (61), the output signal of which is fed to the demodulation unit, the latter comprising an EX-OR unit (67), to the one input of which is passed the said output signal and to other input of which is passed a phase a phase reference signal, and in that the output of the EX-OR unit (67) reverses a bipolar DC signal (73).

16. Negative feedback series-parallel measuring circuit according to one of claims 10 to 15, characterised in that the vibrating capacitance is excited by a vibrating air column (53, 48, 42).

17. Negative feedback series-parallel measuring circuit according to claim 16, characterised in that one plate (38) of the vibrating capacitance is mounted on a vibrating membrane (42), which is excited via an air conductor (48) from a remote vibration pick-up (53), such as an electromagnetic pick-up.

18. Negative feedback series-parallel measuring circuit according to one of claims 10 to 17, characterised in that in order to compensate for any residual influence from a disturbance variable, a current conductor (77) is passed through the area of the input amplifier (7), which is acted upon by an A.C. current ($i_{KOMP}$) of the vibrating capacitance excitation frequency ($f_{mod}$), which is phase and/or amplitude-adjustable.

**Revendications**

1. Procédé de mesure d'une tension continue ou d'une tension à variation lente (W) aux bornes de ou en série avec une impédance ($Z_G$) à valeur ohmique très élevée, en particulier une capacité ($C_G$) de qualité très élevée, ou une source de tension ($WZ_G$) à valeur ohmique très élevée, au moyen d'un circuit amplificateur à contre-réaction série-parallèle comportant un amplificateur d'entrée (7) associé à une capacité oscillante (C(t)) montée en amont, dont la valeur capacitive est réglable par une oscillation à fréquence fixe prédéterminée et qui est chargée par la tension à mesurer (W), de sorte qu'il apparaît, au niveau de la capacité oscillante (C(t)), une tension alternative modulée en amplitude avec la charge qui est filtrée et démodulée en un signal fonction de l'amplitude, lequel est ramené dans le circuit d'entrée, caractérisé en ce que le signal ramené, dépendant du signal démodulé fonction de la charge, est superposé par sommation (P) à un signal dépendant du courant traversant la capacité oscillante (C(t)), et en ce que le signal résultant (X) est placé en contre-réaction par rapport à la tension à mesurer (W).

2. Procédé selon la revendication 1, caractérisé en ce qu'au courant traversant la capacité oscillante (C(t) 36, 38), on superpose, en tant que signal de courant, le signal démodulé fonction de la charge.

3. Procédé selon la revendication 1 ou 2, caractérisé en ce qu'avant la démodulation, on amplifie, côté tension alternative, le signal fonction de la charge.

4. Procédé selon l'une des revendications 1 à 3, caractérisé en ce que l'on conçoit le circuit régulateur, sans prendre en compte la variance dans le temps de la capacité oscillante, pour déjà obtenir, en l'absence de superposition du signal fonction de la charge, un régime séquentiel rapide en ce qui concerne le signal à mesurer (W).

5. Procédé selon la revendication 4, caractérisé en ce que l'on conçoit le circuit régulateur pour l'obtention d'un bon régime séquentiel en ce qui concerne les signaux avec la fréquence d'oscillation ($f_{mod}$) de la capacité oscillante (C(t), 36, 38).

6. Procédé selon la revendication 5, caractérisé en ce que l'on prélève le signal de tension alternative fonction de la charge à la sortie de grandeurs de réglage (A), montée en contre-réaction, du circuit amplificateur.

7. Procédé selon l'une des revendications 1 à 6, caractérisé en ce que l'on utilise un amplificateur de charge (7) comme amplificateur d'entrée.

8. Procédé selon la revendication 7, caractérisé en ce que l'on envoie le signal démodulé fonction de la charge, comme signal de courant, en un point de sommation de courant (P) de l'amplificateur de charge (7).

9. Procédé selon l'une des revendications 1 à 8, caractérisé en ce que l'on compense les influences résiduelles de grandeurs perturbatrices par introduction d'un champ alternatif réglable en amplitude (79) et/ou en phase (81) à l'entrée du circuit amplificateur. avec une fréquence ($f_{mod}$) correspondant à celle de l'oscillation de la capacité.

10. Circuit de mesure monté en contre-réaction série-parallèle pour la mise en œuvre du procédé selon l'une des revendications 1 à 9, comportant un amplificateur d'entrée (7) associé à une capacité oscillante (C(t). 36. 38) connectée en amont ainsi qu'à une unité de démodulation (13, 15, 17 ; 61, 63, 65, 67, 73, 71, 75) connectée en aval pour le signal alternatif produit par la capacité oscillante, et dans lequel un signal dépendant du signal de sortie de l'unité de démodulation est ramené à l'entrée du circuit de mesure, caractérisé en ce que, pour un signal dépendant du courant traversant la capacité oscillante (C(t), 36, 38) et le signal démodulé fonction de la charge de la capacité oscillante, il est prévu une unité de superposition (point de sommation de 7), dont la sortie (A) est montée en contre-réaction par rapport à la tension à mesurer (W) au niveau de l'entrée (E₂) du circuit de mesure.

11. Circuit de mesure monté en contre-réaction série-parallèle selon la revendication 10, caractérisé en ce que l'amplificateur d'entrée est un amplificateur de charge (7), dont la capacité oscillante (C(t)) représente au moins une partie de l'impédance d'entrée (Z_G, Z_S, Z_V).

12. Circuit de mesure monté en contre-réaction série-parallèle selon la revendication 10, caractérisé en ce que l'unité de superposition est un nœud d'addition de courant situé à l'entrée de l'amplificateur de charge.

13. Circuit de mesure monté en contre-réaction série-parallèle selon l'une des revendications 10 à 12, caractérisé en ce que la branche de transmission ouverte depuis la capacité oscillante jusqu'à la sortie de grandeurs de réglage (A) du circuit, présente déjà en l'absence l'introduction du signal fonction de la charge de la capacité oscillante, une amplification élevée, au moins jusqu'à la fréquence d'excitation (f_mod) de la capacité oscillante (C(t), 36, 38).

14. Circuit de mesure monté en contre-réaction série-parallèle selon la revendication 13, caractérisé en ce qu'en aval de la sortie de grandeurs de réglage (A), est connecté un amplificateur de tension alternative (15, 61), dont la sortie est dirigée sur l'unité de démodulation (17).

15. Circuit de mesure monté en contre-réaction série-parallèle selon la revendication 13, caractérisé en ce qu'à la sortie de grandeurs de réglage (A), est connecté, par l'intermédiaire d'un filtre passe-haut (61), un circuit de mise en forme d'impulsions (65), dont le signal de sortie est transmis à l'unité de démodulation, cette dernière comprenant un dispositif ou exclusif (67) dont une entrée reçoit ledit signal de sortie et dont l'autre entrée reçoit un signal de phase de référence, et en ce que la sortie du dispositif ou exclusif (67) inverse un signal de courant continu bipolaire (73).

16. Circuit de mesure monté en contre-réaction série-parallèle selon l'une des revendications 10 à 15, caractérisé en ce que la capacité oscillante est excitée par l'intermédiaire d'une colonne d'air oscillante (53, 48, 42).

17. Circuit de mesure monté en contre-réaction série-parallèle selon la revendication 16, caractérisé en ce que l'une des plaques (38) de la capacité oscillante est montée sur une membrane oscillante (42) qui est excitée, par l'intermédiaire d'une conduite d'air (48), par un émetteur d'oscillations placé à l'écart (53), tel qu'un émetteur électromagnétique.

18. Circuit de mesure monté en contre-réaction série-parallèle selon l'une des revendications 10 à 17, caractérisé en ce que, pour contrebalancer une influence résiduelle de grandeurs perturbatrices, un conducteur de courant (77) est mis en place dans la zone de l'amplificateur d'entrée (7), ce conducteur étant alimenté par un courant alternatif (i_KOMP) de la fréquence d'excitation de la capacité oscillante (f_mod), réglable en phase et/ou en amplitude.

FIG.1

FIG.2

FIG.3

FIG. 4a

FIG. 4 b

FIG.5

FIG. 6

1

FIG. 7

FIG. 8a

FIG. 8b

2

FIG.9

3